# FASCICULE DE BREVET EUROPEEN

(11) **EP 3 375 265 B1**
(45) Date de publication et mention de la délivrance du brevet: **09.12.2020**
(21) Numéro de dépôt: 16822908.6
(22) Date de dépôt: 11.11.2016
(51) Int. Cl.: H05K 5/00, H05K 7/14, H05K 7/20

(54) **ENSEMBLE FORMANT BOITIER POUR UN EQUIPEMENT ELECTRIQUE**
ANORDNUNG ZUR HERSTELLUNG EINES GEHÄUSES FÜR ELEKTRISCHE AUSRÜSTUNG
ASSEMBLY FORMING A CASING FOR ELECTRICAL EQUIPMENT

(30) Priorité: 13.11.2015 FR 1560864
(43) Date de publication de la demande: 19.09.2018
(73) Titulaire: Valeo Siemens eAutomotive France SAS, 95800 Cergy (FR)
(72) Inventeur: SANVITO, Guillaume, 78990 Elancourt (FR); SMAL, Pierre, 78500 Sartrouville (FR)
(74) Mandataire: Argyma
(86) Numéro de dépôt international: PCT/EP2016/077419
(87) Numéro de publication internationale: WO 2017/081243

(56) Documents cités:
- EP-A1- 2 876 988
- KR-A- 20110 139 038
- US-A- 5 156 556

## Description

La présente invention concerne un ensemble formant boitier pour un équipement électrique, et un équipement électrique comprenant un ensemble selon l'invention, notamment pour des applications dans le domaine de l'automobile.

On connait un onduleur pour commander une machine électrique embarquée dans un véhicule. La machine embarquée dans le véhicule peut permettre d'entrainer les roues du véhicule. Un tel onduleur peut comprendre une unité électronique de puissance comprenant des composants par lesquels passe l'énergie alimentant la machine électrique ; et une unité électronique de commande comprenant des composants pour contrôler les composants de l'unité électronique de puissance.

On connait également des convertisseurs de tension continu/continu (DC/DC) embarqués dans un véhicule qui réalisent une conversion de tension entre un premier réseau électrique et un deuxième réseau électrique du véhicule. Typiquement, le premier réseau électrique est un réseau basse tension délivrant une tension inférieure à 60V, notamment de 18 ou 12V environ, et le deuxième réseau électrique est un réseau haute tension qui délivre une tension supérieure à 60V, notamment supérieure à 100, 200, voire 400V. Afin de gagner en densité d'intégration dans le véhicule, l'onduleur et le convertisseur DC/DC peuvent être intégrés dans un seul équipement électrique à l'intérieur du véhicule.

L'onduleur et le convertisseur DC/DC subissent un échauffement lié à leur environnement, mais qui est aussi lié aux puissances élevées qui circulent à travers eux lorsque la machine électrique fonctionne à haute tension ou lorsque le convertisseur DC/DC réalise une conversion haute-basse tension.

Afin d'obtenir un refroidissement efficace de l'onduleur et du convertisseur DC/DC, il est connu de prévoir un boitier d'équipement électrique en deux parties dans lequel les composants de l'onduleur et du convertisseur DC/DC sont répartis entre les deux parties, un circuit de refroidissement étant prévu entre les deux parties de boitier. Par exemple, la publication de demande de brevet KR20110139038 A décrit un tel boîtier d'équipement électrique dans lequel un premier boitier comprend les composants de l'onduleur et un deuxième boitier comprend les composants du convertisseur DC/DC. Une paroi du premier boitier vient contre une paroi du deuxième boitier pour définir des canaux de circulation d'un fluide de refroidissement.

Cependant, la réalisation d'un tel boitier en deux parties est complexe et pose des problèmes liés à la tenue de l'étanchéité du circuit de refroidissement ou à l'intégration des composants dans le boitier en deux parties.

L'invention cherche à résoudre au moins en partie les problèmes de l'art antérieur en proposant un ensemble formant boitier pour un équipement électrique, ledit ensemble comprenant :
- un premier boîtier destiné à recevoir au moins un premier composant électronique dudit équipement électrique ;
- un deuxième boitier destiné à recevoir au moins un deuxième composant électronique dudit équipement électrique ;
une première paroi, dite première paroi d'interface, du premier boîtier et une deuxième paroi, dite deuxième paroi d'interface, du deuxième boitier étant configurées pour venir en appui l'une contre l'autre pour former ledit ensemble ;
ensemble dans lequel :
- le premier et le deuxième boîtiers comprennent chacun au moins une paroi latérale, dites respectivement première et deuxième parois latérales, s'étendant respectivement depuis la première paroi d'interface et la deuxième paroi d'interface dans une direction opposée à l'autre boitier ; et
- la deuxième paroi latérale comprend une ouverture, dite ouverture de connexion, destinée à recevoir un connecteur électrique et une portion autour de la dite ouverture, dite portion de connexion, destinée à recevoir une pièce d'étanchéité dudit connecteur électrique, lesdites première et deuxième parois latérales étant configurées de sorte que ladite portion de connexion s'étend en direction du premier boitier de manière à venir en vis-à-vis d'une face externe de la première paroi latérale.

En faisant déborder la portion de connexion sur le premier boitier, on limite la hauteur de la deuxième paroi latérale par rapport à la deuxième paroi d'interface, ce qui diminue l'encombrement de l'ensemble formant boitier de l'équipement électrique, surtout au niveau de son deuxième boitier.

Selon un mode de réalisation, les dites première et deuxième parois latérales forment chacune une paroi extérieure de leur boitier respectif, ladite ouverture de connexion étant configurée pour recevoir un connecteur électrique destiné à connecter électriquement un composant de l'équipement électrique depuis l'extérieur de l'ensemble formant boitier.

Selon un mode de réalisation, au moins une partie de la portion de connexion de la deuxième paroi latérale vient dans un décrochement correspondant situé dans la face de la première paroi latérale.

Selon un mode de réalisation, ladite partie de la portion de connexion a une épaisseur configurée pour correspondre avec la profondeur du décrochement et comprend un trou destiné à recevoir un organe de fixation de la pièce d'étanchéité dudit connecteur électrique sur la dite portion de connexion.

Selon un mode de réalisation :
- la deuxième paroi d'interface comprend une excroissance, ladite excroissance coopérant avec un bord de ladite ouverture de connexion pour permettre un passage d'une connexion électrique entre le connecteur électrique et un composant de l'équipement électrique ;
- la première paroi d'interface comprend un décrochement configuré pour recevoir ladite excroissance de la deuxième paroi d'interface.

L'invention concerne également un équipement électrique comprenant :
- un ensemble selon l'invention,
- au moins un premier composant électrique logé dans le premier boitier,
- au moins un deuxième composant électrique logé dans le deuxième boitier,
- un premier connecteur électrique passant à travers l'ouverture de connexion et connecté électriquement à un composant électrique de l'équipement électrique, une pièce d'étanchéité du premier connecteur électrique étant fixée sur la dite portion de connexion.

Selon un mode de réalisation, l'équipement électrique comprend :
- des interrupteurs d'un onduleur et/ou des interrupteurs d'un convertisseur de tension DC/DC logés dans le premier boitier ; et
- des composants de filtrage et de redressement logés dans le deuxième boîtier.

Selon un mode de réalisation, le premier connecteur électrique est destiné à permettre un échange d'énergie électrique entre les composants de l'équipement électrique et un composant extérieur à l'équipement électrique.

Selon un mode de réalisation, la première et la deuxième paroi comprennent respectivement au moins un trou traversant dont les bords viennent en correspondance pour former un passage pour une connexion électrique entre le premier et le deuxième composant électrique.

Selon un mode de réalisation, la connexion électrique entre le premier et le deuxième composant est réalisée par un deuxième connecteur électrique comprenant :
- une pièce rigide conductrice électriquement couverte d'un revêtement en matière isolante électriquement,
- une première extrémité connectée électriquement à une borne électrique du premier composant, et
- une deuxième extrémité connectée électriquement à une borne du deuxième composant.

L'invention va être décrite en détail dans la description qui suit en liaison avec les dessins ci-annexés. Il est à noter que ces dessins n'ont d'autre but que d'illustrer le texte de la description et ne constituent en aucune sorte une limitation de la portée de l'invention.
Les figures 1 et 2 sont des vues en perspective d'un exemple d'équipement électrique 1 selon l'invention.
Les figures 3 et 4 sont respectivement des vues d'un premier logement et d'un deuxième logement de l'équipement électrique lorsque les couvercles sont enlevés.
La figure 5 est une vue en coupe de l'équipement électrique.
Les figures 6 et 7 sont d'autres vues du premier logement de l'équipement électrique avec certains composants enlevés.
Les figures 8 et 9 sont des vues en coupe de l'ensemble formant boitier de l'équipement électrique.
Les figures 10 et 11 sont des vues en perspective du premier boitier de l'ensemble.
La figure 12 représente un joint d'étanchéité inséré entre le premier et le deuxième boitier de l'ensemble.
Les figures 13 et 14 sont des vues en perspective du deuxième boitier de l'ensemble.
La figure 15 est une vue en perspective de l'ensemble formant boitier.
Les figures 16 à 19 sont des vues de détail de l'ensemble formant boitier.
La figure 20 est une vue en perspective d'un connecteur électrique utilisé dans l'équipement électrique.
La figure 21 est une vue en perspective du connecteur de la figure 20 sans son revêtement.

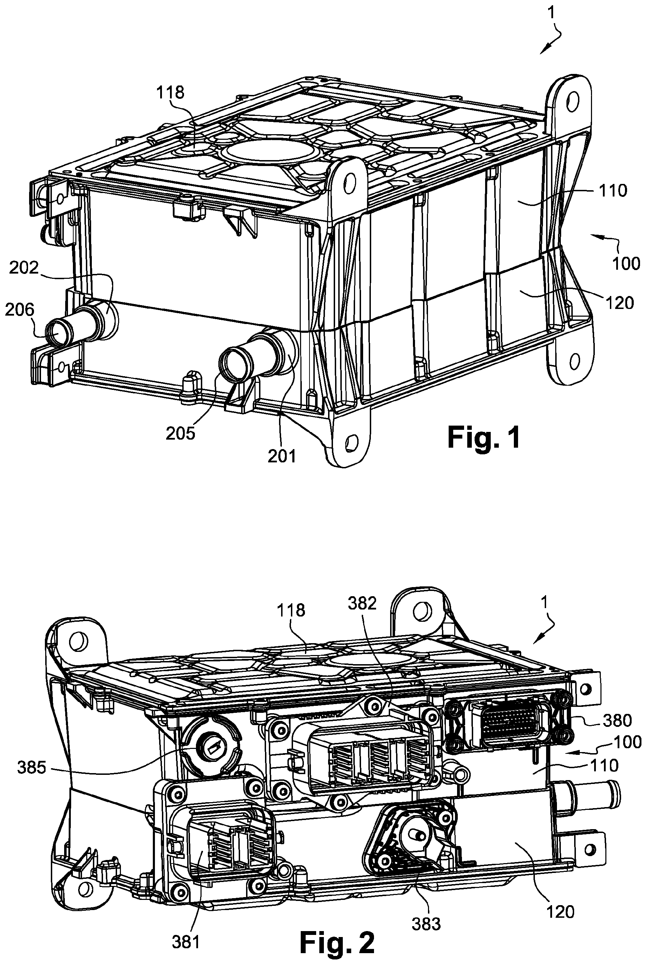

Les figures 1 et 2 montrent des vues en perspective d'un exemple d'équipement électrique 1 selon l'invention. L'équipement électrique 1 comprend un ensemble 100 qui loge les composants de l'équipement électrique. L'équipement électrique 1 comprend notamment un onduleur destiné à alimenter une machine électrique telle qu'une machine électrique tournante, par exemple une machine destinée à entrainer les roues d'un véhicule. L'équipement électrique 1 comprend notamment un convertisseur DC/DC destiné à convertir une tension entre un premier réseau électrique continu et un deuxième réseau électrique continu du véhicule.

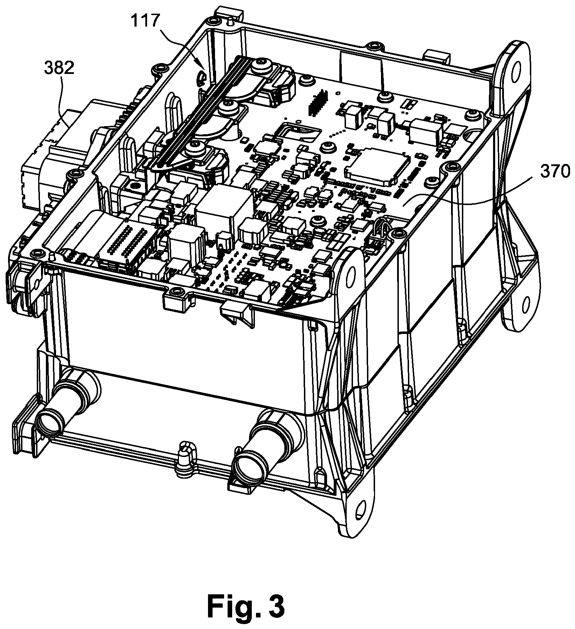

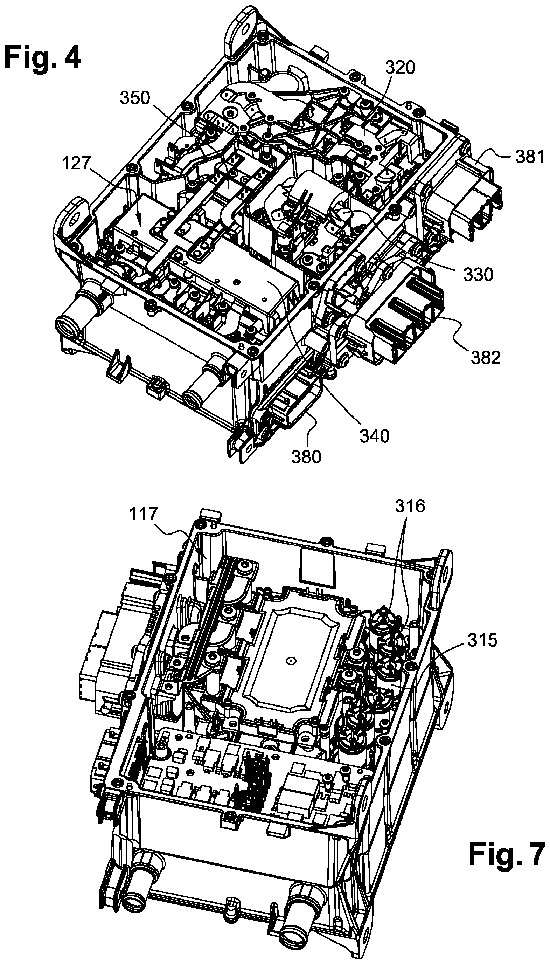

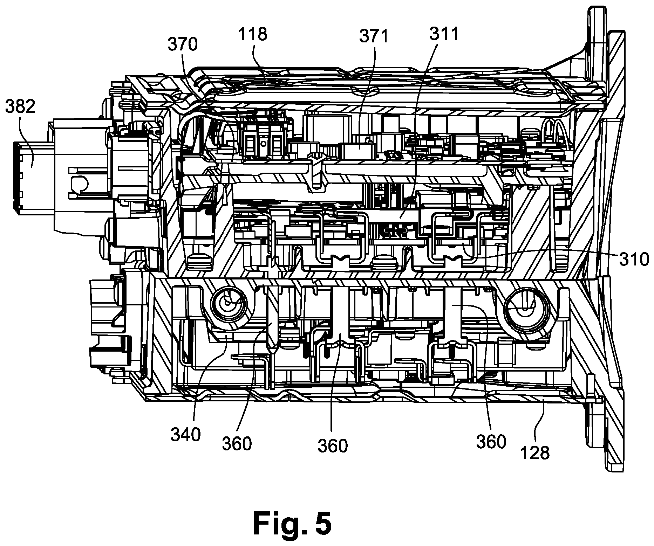

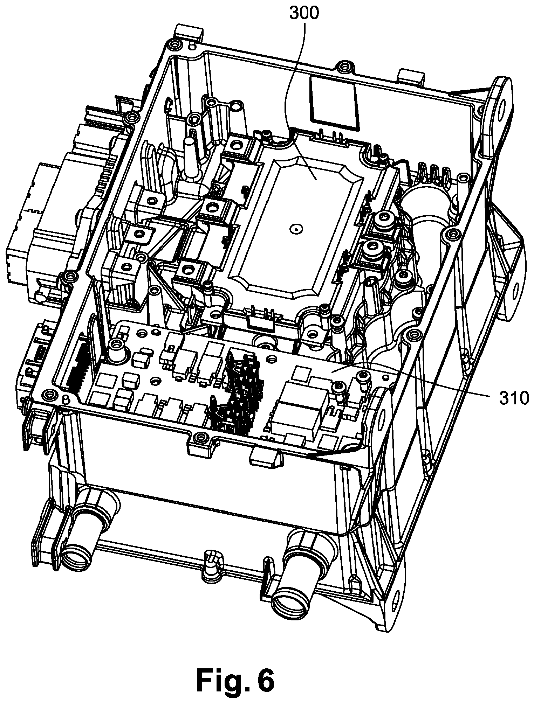

L'ensemble 100 de l'équipement électrique 1 comprend un premier boiter 110 et un deuxième boitier 120. Le premier boitier 110 reçoit un ou des premiers composants de l'équipement électrique 1, illustrés par exemple en figures 3 et 5 à 7. Le deuxième boitier 120 reçoit un ou des deuxièmes composants électriques, illustrés par exemple en figure 4 et 5.

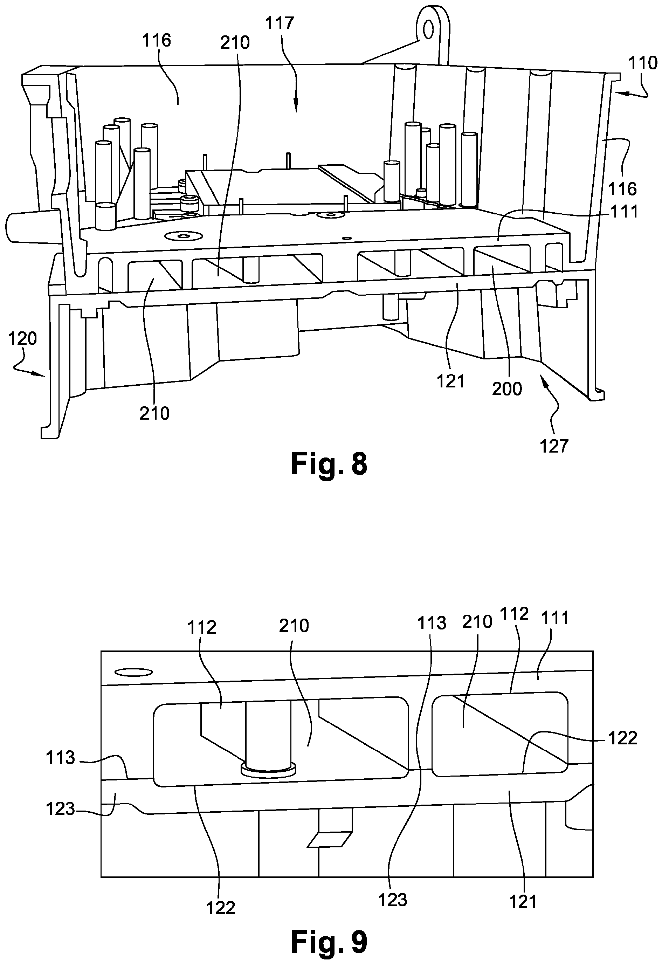

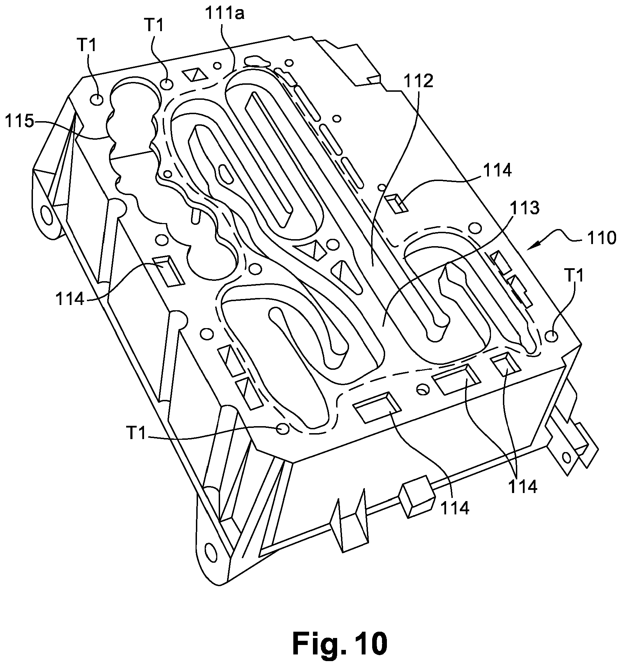

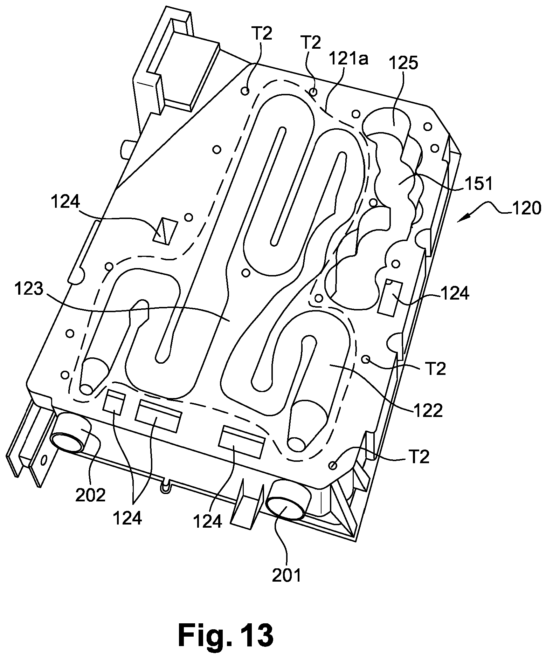

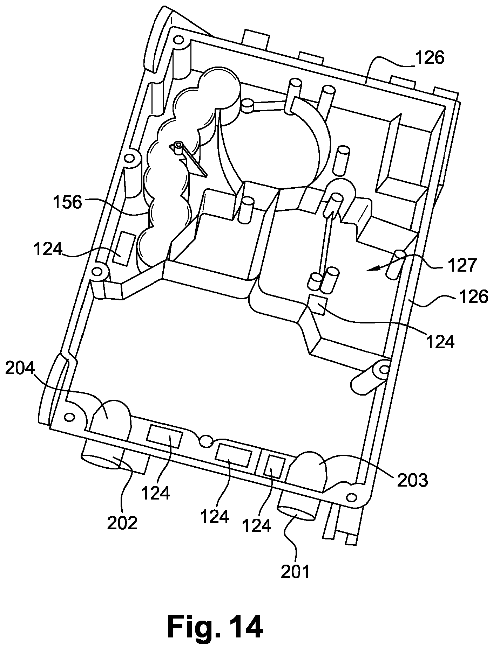

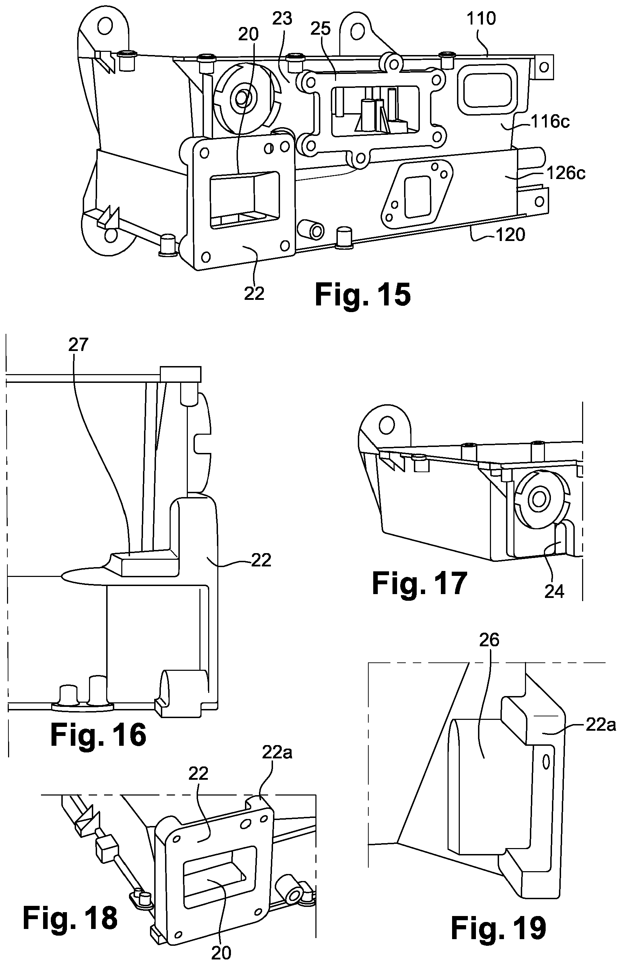

Des exemples de premier 110 et deuxième 120 boitiers sont illustrés en figures 8 à 19. Le premier boîtier 110 comprend une première paroi 111 qui vient en appui avec une deuxième paroi 121 du deuxième boitier 120 pour former l'ensemble 100 formant boitier de l'équipement électrique 1. La première paroi 111 et la deuxième paroi 121 sont désignées dans ce qui suit comme première paroi d'interface 111 et deuxième paroi d'interface 121. En particulier, les bords périphériques de la première paroi d'interface 111 et de la deuxième paroi d'interface 121 viennent en vis-à-vis lorsque le premier boitier 110 est monté sur le deuxième boitier 120.

Chaque boitier 110, 120 comprend des parois latérales respectives 116, 126 qui s'étendent respectivement depuis la première paroi d'interface 111 et la deuxième paroi d'interface 121. En particulier, les parois latérales 116, 126 s'étendent transversalement depuis la périphérie de la première 111 ou de la deuxième 121 paroi d'interface de manière à définir un premier logement 117 et un deuxième logement 127 respectifs. Lorsque les premier 110 et deuxième 120 boitiers sont montés l'un sur l'autre, les parois latérales 116 du premier boitier 110 s'étendent dans une direction opposée par rapport au deuxième boitier 120 et les parois latérales 126 du deuxième boitier 120 s'étendent dans une direction opposée par rapport au premier boitier 110. Chaque logement 117, 127 peut être fermé par un couvercle respectif 118, 128 qui vient contre les extrémités distales des dites parois latérales 116, 126. Ainsi, la première paroi d'interface 111 forme un fond du premier boitier 110 et la deuxième paroi d'interface 121 forme un fond du deuxième boitier 120. La première paroi d'interface 111 et la deuxième paroi d'interface 121 forment une interface entre le premier logement 117 et le deuxième logement 127. En particulier, les premières parois latérales 116 du premier boitier 110 forment des parois extérieures du premier boitier 110 ; et les deuxièmes parois latérales 126 du deuxième boitier 120 forment des parois extérieures du deuxième boitier 120.

Notamment, dans chaque boitier 110, 120 les parois latérales 116, 126 et la paroi d'interface 111, 121 sont d'un seul tenant.

Une des deuxièmes parois latérales 126, dite deuxième paroi de connexion 126c, comprend une ouverture 20, dite ouverture de connexion, qui reçoit un connecteur électrique 381 (visible en figure 2) de l'équipement électrique 1. Le connecteur électrique 381 est notamment destiné à connecter électriquement un composant 320 de l'équipement électrique 1 depuis l'extérieur de l'ensemble 100 formant boitier de l'équipement électrique 1. La deuxième paroi de connexion 126c comprend une portion 22, dite portion de connexion, qui entoure l'ouverture de connexion 20. Notamment, la portion de connexion 22 entoure immédiatement l'ouverture de connexion 20. Lorsque l'ouverture de connexion 20 reçoit le connecteur électrique 381, une pièce d'étanchéité 381a du connecteur électrique 381 vient contre la portion de connexion 22 pour réaliser une étanchéité du connecteur électrique 381. La pièce d'étanchéité 381a du connecteur électrique 381 est par exemple en matière plastique non conductrice électriquement. La pièce d'étanchéité 381a réalise également l'isolation électrique et le maintien mécanique du connecteur 381 dans l'ouverture de connexion 20 en recevant par exemple des vis pour une fixation sur la portion de connexion 22. La portion de connexion 22 de la deuxième paroi de connexion 126c s'étend en direction du premier boitier 110 pour venir en vis-à-vis d'une face 23 d'une des premières parois latérales 116, dite première paroi de connexion 116c. Notamment, la portion de connexion 22 de la deuxième paroi de connexion 126c vient contre la face 23 de la première paroi de connexion 116c. La face 23 est notamment une face latérale externe du premier boitier 110. Ainsi, la portion de connexion 22 de la deuxième paroi de connexion 126c vient recouvrir en partie la première paroi de connexion 116c. La portion de connexion 22 de la deuxième paroi de connexion 126c s'étend donc au-delà de la deuxième surface d'appui 123 vers le premier boitier 110.

Les hauteurs des première et deuxième parois latérales 116, 126 définissent avec, respectivement la première paroi d'interface 111 et la deuxième paroi d'interface 121, les volumes disponibles dans le premier logement 117 et le deuxième logement 127 pour loger les premiers et les deuxièmes composants. Dans un boitier de l'art antérieur, il pourrait arriver que les premières 116 et deuxièmes 126 parois latérales, aient des hauteurs plus importantes qu'il est nécessaire pour loger les composants. Notamment, la pièce d'étanchéité d'un connecteur doit venir contre une surface suffisante pour réaliser l'étanchéité. Cela entraine une surface minimale pour la portion de connexion et donc une dimension minimale de la paroi qui porte la portion de connexion, si l'on tient compte de la surface de la portion de connexion correspondante sur le boitier et de la dimension de l'ouverture de connexion. Dans l'ensemble 100 formant boitier de l'équipement électrique 1, en permettant un débordement de la portion de connexion 22 du deuxième boitier 120 sur le premier boitier 110, on enlève une contrainte sur la hauteur des parois latérales 126 du deuxième boitier 120. Ainsi, la hauteur des parois latérales 126 du deuxième boitier peut être plus faible, pour correspondre au plus juste à une hauteur nécessaire pour loger les deuxièmes composants. En outre, il est préférable que la portion de connexion 22 soit d'un seul tenant pour éviter des problèmes d'étanchéité.

En particulier, la première paroi d'interface 111 et la deuxième paroi d'interface 121 viennent en appui l'une contre l'autre au niveau de surfaces respectives, dites première 113 et deuxième 123 surfaces d'appui (visibles notamment en figures 8, 9). La première paroi d'interface 111 comprend en outre une première surface 153, dite première surface d'interface, opposée à la première surface d'appui 113 et située du côté du premier logement 117. La deuxième paroi d'interface 121 comprend une deuxième surface 154, dite deuxième surface d'interface, opposée à la deuxième surface d'appui 123 et située du côté du deuxième logement 127. Notamment, les premières parois latérales 116 s'étendent depuis la première surface d'interface 153 de la première paroi d'interface 111 ; et les deuxièmes parois latérales 126 s'étendent depuis la deuxième surface d'interface 154 de la deuxième paroi d'interface 121.

Notamment, la portion de connexion 22 de la deuxième paroi de connexion 126c est reçue contre la face 23 de la première portion de connexion 116c de manière que la surface de la portion de connexion 22 affleure avec la surface d'une portion de connexion 25 située dans la première paroi de connexion 116c. Cela limite les irrégularités sur le côté de l'ensemble 100 et facilite son intégration.

En particulier, la portion de connexion 22 de la deuxième paroi de connexion 126c vient dans un décrochement 24 correspondant du premier boitier 110. Notamment, le décrochement 24 est situé dans la face 23 de la première paroi de connexion 116c. Le décrochement 24 aménagé dans le premier boitier 110 entraine une perte d'espace limitée dans le premier logement 117 et n'impacte pas la densité d'intégration des composants dans le premier logement 117.

En particulier, seule une partie 22a de la portion de connexion 22 vient dans le décrochement 24. La partie 22a a une épaisseur qui correspond avec la profondeur du décrochement 24. Notamment, la partie 22a est plus épaisse que le reste de la portion de connexion 22 afin de recevoir un organe de fixation de la pièce d'étanchéité 381a du connecteur électrique 381. A cet effet, la partie 22a peut comprendre un trou pour recevoir une vis par exemple. En prévoyant une épaisseur plus importante au niveau de la partie 22a recevant l'organe de fixation, on obtient suffisamment de matière pour permettre une prise de l'organe de fixation qui solidarise la pièce d'étanchéité du connecteur électrique 380 et la portion de connexion 22. L'épaisseur de la portion de connexion 22 reste plus faible ailleurs afin de faciliter le refroidissement après une fonte du deuxième boiter 120.

Notamment, la deuxième paroi d'interface 120 comprend une excroissance 26 qui coopère avec un bord de l'ouverture de connexion 20 pour permettre le passage de la connexion électrique entre le connecteur électrique 381 et un composant de l'équipement électrique 1. En particulier, l'excroissance 26 s'étend la deuxième surface d'appui 123 et forme une paroi dont une extrémité est en contact avec les bords de l'ouverture de connexion 20. Ainsi, l'excroissance 26 définit un passage pour le conducteur électrique du connecteur électrique 381a. Un décrochement 27 est aménagé dans la première paroi d'interface 111 pour recevoir l'excroissance 26 de la deuxième paroi d'interface 121. Grâce à l'excroissance 26, l'ouverture de connexion 20 de la deuxième paroi de connexion 126c peut être décalée vers le premier boitier 110, ce qui permet de diminuer encore les contraintes sur la hauteur de la deuxième paroi latérale de connexion 126c.

L'équipement électrique 1 peut comprendre un circuit de refroidissement 200 formé par la première paroi d'interface 111 et la deuxième paroi d'interface 121 lors de la mise en appui de la première paroi d'interface 111 contre la deuxième paroi d'interface 121. Le circuit de refroidissement 200 reçoit un fluide destiné à refroidir l'équipement électrique 1. La première paroi d'interface 111 comprend une gorge 112 qui vient en vis-à-vis avec une gorge 122 de la deuxième paroi 120 pour former le circuit de refroidissement 200.

En particulier, la première gorge 112 et la deuxième gorge 122 viennent en vis-à-vis pour former un canal 210 du circuit de refroidissement dans lequel va circuler le fluide de refroidissement. Ainsi, le diamètre du canal de refroidissement est réparti entre les deux parois. Cela permet de répartir entre les deux parois les contraintes sur l'épaisseur de paroi qui sont dues à la formation du circuit de refroidissement 200 et d'équilibrer entre eux le premier logement 117 et le deuxième logement 127.

En particulier, la première paroi d'interface 111 et la deuxième paroi d'interface 121 viennent l'une contre l'autre au niveau des surfaces d'appui 113, 123. Les surfaces d'appui 113, 123 sont sensiblement planes dans les zones 111a, 121b des parois d'interface 111, 121 qui forment le circuit de refroidissement 200. La surface d'appui 113 de la première paroi d'interface 111 comprend les bords de la première gorge 112 ; et la surface d'appui 123 de la deuxième paroi d'interface 121 comprend les bords de la deuxième gorge 122. On entend par bord de la première 112 ou de la deuxième 122 gorge, la frontière entre la gorge 112, 122 et la surface depuis laquelle la gorge 112,122 se creuse. La surface depuis laquelle la première gorge 112 se creuse correspond notamment à la surface d'appui 113 de la première paroi d'interface 111 ; et la surface depuis laquelle la deuxième gorge 122 se creuse correspond notamment à la surface d'appui 123 de la deuxième paroi d'interface 121. En particulier, les bords de la première 112 ou deuxième 122 gorges sont intégralement compris dans leur surface d'appui 113, 123 respective.

La première paroi d'interface 111 peut comprendre au moins un trou traversant 114 et la deuxième paroi d'interface 121 peut comprendre au moins un trou traversant 124, dont les bords viennent en contact l'un sur l'autre pour former un passage entre le premier logement 117 défini par le premier boitier 110 et le deuxième logement 127 défini par le deuxième boitier 120. En particulier, ces trous traversants 114, 124 forment un passage entre la première surface d'interface 153 et la deuxième surface d'interface 154. Ces trous traversants 114, 124, sont notamment formés à l'extérieur des zones 111a, 121a des première 111 et deuxième 121 parois qui forment le circuit de refroidissement 200.

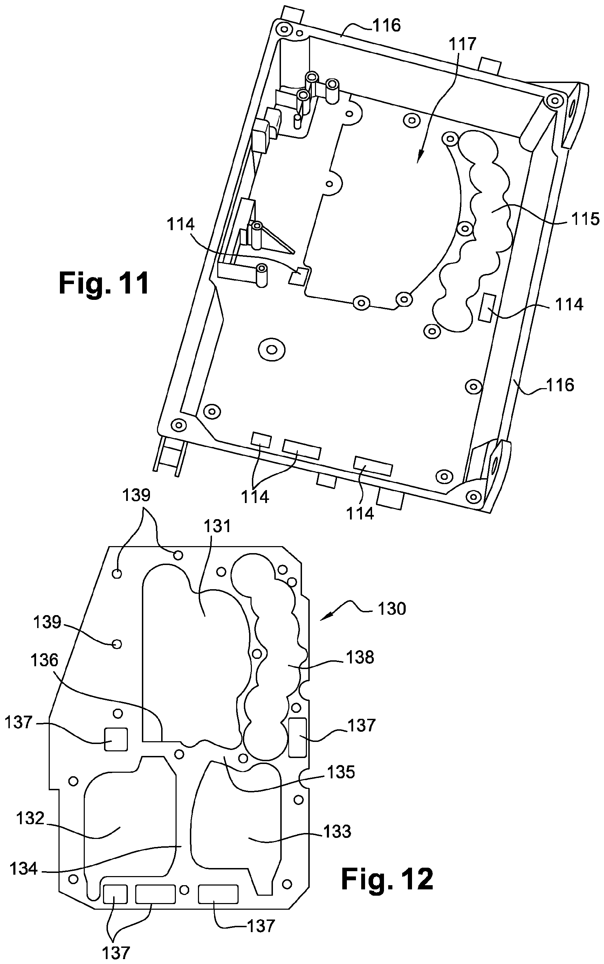

Un joint d'étanchéité peut être positionné entre la première paroi d'interface 111 et la deuxième paroi d'interface 121. Un exemple de joint d'étanchéité 130 est illustré en figure 12. Le joint d'étanchéité 130 réalise en particulier une étanchéité autour des zones 111a, 121a des première 111 et deuxième 121 parois d'interface qui forment le circuit de refroidissement 200. A cet effet, le joint d'étanchéité 130 vient notamment entre les surfaces d'appui 113, 123 de la première paroi d'interface 111 et de la deuxième paroi d'interface 121. Le joint d'étanchéité 130 peut être dépourvu de matière dans une partie qui se situe dans le circuit de refroidissement 200 lorsqu'il est formé, à l'exception de bandes de matière 134, 135,136. Ces bandes de matière 134, 135, 136 améliorent la rigidité du joint d'étanchéité 130 de manière à faciliter la manutention et le placement du joint d'étanchéité 130. Ces bandes de matière 134, 135,136 peuvent avoir des largeurs juste suffisantes pour obtenir une rigidité et définissent des ouvertures 131, 132, 133. Le joint d'étanchéité 130 réalise une étanchéité le long d'une ligne fermée autour du circuit de refroidissement 200, notamment autour des zones 111a, 121a des parois 111, 121 qui forment le circuit de refroidissement 200. Le joint d'étanchéité 130 peut également réaliser l'étanchéité autour des passages formés dans la première paroi d'interface 111 et la deuxième paroi d'interface 121. Le joint d'étanchéité 130 comprend alors des trous 137 dont les bords réalisent l'étanchéité autour desdits passages. Le joint d'étanchéité 130 peut aussi comprendre des trous 139 qui permettent le passage d'organes de fixation respectifs pour la fixation de la première paroi d'interface 111 sur la deuxième paroi d'interface 121.

Le circuit de refroidissement 200 peut comprendre un port d'entrée 201 et un port de sortie 202 par lesquels le fluide de refroidissement entre et sort du circuit de refroidissement 200. Les ports d'entrée 201 et de sortie 202 sont compris dans le deuxième boitier 120, en particulier dans une paroi latérale 126 du deuxième boitier 120. Notamment, les ports d'entrée/sortie 201, 202 sont des ouvertures tubulaires dans la paroi latérale 116. Ces ports d'entrées/sorties 201,202 sont prolongés par des tubes 203, 204 qui communiquent avec la deuxième gorge 122 de la deuxième paroi d'interface 121 pour y acheminer ou y extraire le fluide de refroidissement. Des embouts 205, 206 peuvent être insérés dans les ports d'entrée/sortie 201, 202 pour les adapter à un circuit d'alimentation en fluide de refroidissement.

Le premier boitier 110 peut recevoir un ou plusieurs premiers composants 300, 310, par exemple comme illustré en figure 7. Le premier logement 117 peut comprendre un module électronique de puissance 300 faisant parti de l'onduleur. Le module électronique de puissance 300 comporte des composants destinés à alimenter la machine électrique Le premier logement 117 peut comprendre une carte électronique à substrat métallique isolée (SMI ou « Insulated Molded Substrate » en anglais) 310 faisant parti du convertisseur DC/DC. La carte SMI porte des composants pour la conversion de tension entre le premier et le deuxième réseau électrique du véhicule. Ces modules électroniques de puissance 300 et la carte SMI 310 peuvent être supportées par la première paroi d'interface 111, avec une de leur face venant en contact avec la première paroi d'interface 111. Notamment, ces premiers composants 300, 310 sont situés sur une face de la première paroi d'interface 111 qui est opposée à la face portant la première gorge 111. En particulier, le module électronique de puissance 300, ou la carte SMI 310 peuvent être situés au moins en partie sur une surface qui est opposée à la première gorge 111, ce qui améliore leur refroidissement. Les composants du module de puissance 300 ou de la carte SMI comprennent par exemple des interrupteurs électroniques, tels que des transistors semiconducteurs, ou autres.

Le deuxième boitier 120 peut recevoir un ou plusieurs deuxièmes composants 320, 330, 340, 350 logés dans le deuxième logement 127, par exemple comme illustré en figure 4. Le deuxième logement 127 peut comprendre un filtre de compatibilité électromagnétique (ou EMC) 320 pour filtrer un signal d'entrée de l'équipement électrique 1, et/ou un filtre EMC 330 pour filtrer un signal de sortie de l'équipement électrique 1, et/ou un composant magnétique 340 comportant une inductance pour la rectification d'un courant délivré au module de puissance 300 et un transformateur pour le convertisseur DC/DC de l'équipement électrique 1 et/ou un module capacitif 350 destiné à permettre un commutation à zéro de tension (ou ZVS) des commutateurs électriques compris dans le module électronique 300 et/ou sur la carte SMI 310. Ces deuxièmes composants 320, 330, 340, 350 peuvent être supportés par la deuxième paroi d'interface 121, avec une de leur face venant en contact avec la deuxième paroi d'interface 121. Notamment, ces deuxièmes composants 320, 330, 340, 350 sont situés sur une face de la deuxième paroi d'interface 121 qui est opposée à la face portant la deuxième gorge 121. Dans la mesure du possible, les deuxièmes composants 320, 330, 340, 350 peuvent être situés au moins en partie sur une surface qui est opposée à la deuxième gorge 121, ce qui améliore leur refroidissement.

Les premiers composants 300, 310 peuvent être reliés électriquement avec les deuxièmes composants 320, 330, 340, 350, notamment par l'intermédiaire des passages définis par les trous traversants 114, 124 formés dans la première 111 et la deuxième 121 paroi d'interface. La figure 5 illustre un exemple de connexion électrique entre un connecteur électrique 311 de la carte SMI 310 et une borne du composant magnétique 340 par l'intermédiaire d'un connecteur électrique 360.

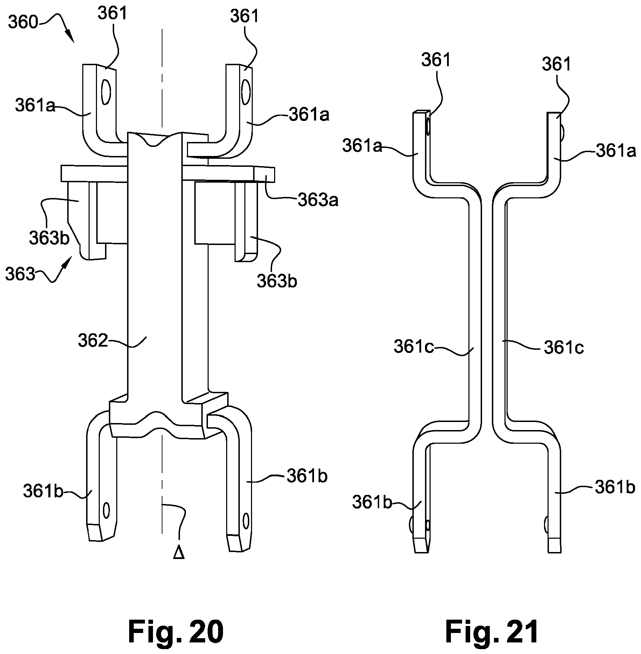

Le connecteur électrique 360 est illustré plus précisément en figures 20, 21. Il comprend deux pièces rigides 361 conductrices électriquement. Les pièces rigides 361 sont couvertes d'un revêtement 362 de matière isolante électriquement, notamment une matière plastique déposée par surmoulage. Chaque pièce rigide 361 comprend une première extrémité 361a connectée à une borne du premier composant, notamment à une borne d'un connecteur électrique 311 de la carte SMI 310 ; et une deuxième extrémité 361b connectée à une borne du deuxième composant, notamment à une borne du composant magnétique 340. Les connexions électriques se font par exemple par soudage ou brasage. Les extrémités 361a, 361b sont reliées par une partie intermédiaire 361c. Chaque extrémité 361a, 361b peut être reliée à la partie intermédiaire 361c par un coude de sorte que les parties intermédiaires 361c des deux pièces 361 sont séparées d'une distance qui est inférieure à celle séparant les premières extrémités 361a et à celle séparant les deuxièmes extrémités 361b. Ainsi, il y a moins de matière isolante au niveau de la partie intermédiaire 361c, ce qui améliore la manipulation du connecteur 360 et diminue son coût. Cependant, le revêtement 362 peut comprendre un organe de guidage 363 situé notamment au niveau de la partie intermédiaire 362, avant le coude séparant la première extrémité 361a de la partie intermédiaire 362. L'organe de guidage 363 comprend une barre 363a qui s'étend dans une direction transversale par rapport à une direction principale Δ du connecteur électrique 360. La direction principale Δ du connecteur électrique 360 correspond notamment à la direction suivant laquelle les parties intermédiaires 361c s'étendent. Lorsque le connecteur électrique 360 est monté dans les passages de connexion formés par les parois d'interface 111, 121, la direction principale Δ s'étend du premier 117 vers le deuxième 127 logement. La barre transversale 363a porte à chaque extrémité une excroissance 363b qui s'étend suivant la direction principale Δ vers la deuxième extrémité 361b. Cet organe de guidage 363 facilite le positionnement du connecteur électrique 360 dans le passage défini par les trous traversants 114, 124 de la première paroi d'interface 111 et la deuxième paroi d'interface 121.

Le connecteur électrique 360 pourrait comprendre une seule pièce 361 conductrice électriquement, par exemple dans le cas où le connecteur 360 fait une connexion électrique entre un seul premier composant et un seul deuxième composant. La pièce 361 conductrice électriquement peut être alors une lame rectiligne.

Selon un mode de réalisation, les interrupteurs électroniques de l'onduleur et du convertisseur DC/DC de l'équipement électrique 1 sont logés dans l'un des deux boitiers 110, 120 alors que les composants de filtrage et de redressement 320, 330, 340, 350 de l'équipement électrique 1 sont logés dans l'autre des deux boitiers. Cela permet de partager les composants de filtrage entre l'onduleur et le convertisseur DC/DC. En outre, en logeant les interrupteurs dans un même boitier, il est plus facile de les contrôler avec une seule unité de contrôle 370. Une telle unité de contrôle 370 est par exemple logée dans le même boitier que les interrupteurs, comme illustré en figure 5. L'unité de contrôle 370 est par exemple une carte électronique portant des composants 371 destinés à contrôler les interrupteurs du module électronique de puissance 300 et de la carte SMI 310. En particulier, les interrupteurs électroniques de l'onduleur et du convertisseur DC/DC de l'équipement électrique 1 sont logés dans le premier boitier 110 alors que les composants de filtrage et de redressement 320, 330, 340, 350 de l'équipement électrique 1 sont logés dans le deuxième boitier 120.

Le premier boitier 110 et le deuxième boitier 120 sont fixés l'un à l'autre par des organes de fixation qui maintiennent la première paroi d'interface 111 en appui contre la deuxième paroi d'interface 121. Ces organes de fixation sont par exemple des vis s'introduisant dans des trous correspondants T1, T2 dans la première paroi d'interface 111 et la deuxième paroi d'interface 121. Les organes de fixation peuvent être aussi des clips, par exemple portés par les parois latérales 116,126 du premier boitier 110 et du deuxième boiter 120.

L'équipement électrique 1 peut comprendre un connecteur signal 380 destiné à permettre un échange de signal de données entre les composants de l'équipement électrique et l'extérieur de l'équipement électrique, par exemple avec un contrôleur du véhicule. L'équipement électrique 1 peut comprendre un connecteur d'entrée de puissance 381 qui permet l'alimentation électrique des composants de l'équipement électrique 1. En particulier, le connecteur d'entrée de puissance 381 permet une connexion électrique avec un premier réseau électrique du véhicule, notamment avec une unité de stockage électrique de ce premier réseau électrique, pour fournir une énergie électrique en entrée de l'onduleur et/ou du convertisseur DC/DC de l'équipement électrique 1. Un connecteur de sortie de puissance 382 peut permettre de transférer une énergie électrique entre l'onduleur de l'équipement électrique 1 et les phases de la machine électrique contrôlée par l'onduleur. Un connecteur électrique de sortie DC/DC 383 peut permettre de transférer une énergie électrique entre le convertisseur DC/DC de l'équipement électrique 1 et un deuxième réseau électrique du véhicule, notamment avec une unité de stockage électrique de ce deuxième réseau électrique. Le premier réseau électrique est par exemple un réseau haute tension et le deuxième réseau électrique est par exemple un réseau basse tension. Ces connecteurs électriques 380, 381, 382, 383 sont notamment sur un côté de l'ensemble 100 formant boitier de l'équipement électrique 1 illustré en figure 2. En particulier, ces connecteurs électriques 380, 381, 382, 383 sont sur des parois latérales 116, 126 du premier 110 et du deuxième 120 boitiers qui sont sur un même côté de l'ensemble 100. Notamment, le connecteur d'entrée de puissance 381 est positionné sur la portion de connexion 22 de la deuxième paroi de connexion 126c. Notamment, le connecteur de sortie de puissance 382 est positionné sur la portion de connexion 25 de la première paroi de connexion 116c. En particulier, le connecteur d'entrée de puissance 381 est connecté électriquement au filtre EMC 320 qui filtre un signal d'entrée de l'équipement électrique 1.

L'équipement électrique 1 peut comprendre un évent 385 pour contrôler l'humidité à l'intérieur de l'équipement électrique 1. L'évent 385 est notamment porté un côté de l'ensemble 100 formant boitier de l'équipement électrique 1. Par exemple, il est porté sur une paroi latérale 116 du premier boitier 110. Il pourrait aussi être porté sur une paroi latérale 126 du deuxième boitier 120.

La première paroi d'interface 111 peut comprendre une ouverture traversante 115 dont les bords viennent en correspondance avec une ouverture 125 de la deuxième paroi 120. Une excroissance 156 s'étend depuis les bords de l'ouverture 125 depuis la deuxième surface d'interface 154. L'excroissance 156 forme une cavité 151 qui reçoit un bloc capacitif 315, visible en figure 7. Le bloc capacitif 315 comprend plusieurs condensateurs 316. Il est connecté à l'onduleur, notamment au module électronique de puissance 300, et au convertisseur DC/DC, notamment à la carte SMI 310. En particulier, le bloc capacitif 315 est dans la liaison électrique entre le premier réseau électrique du véhicule et le module électronique de puissance 300 et la carte SMI 310 et constitue une réserve d'énergie au plus proche du module électronique de puissance 300 et la carte SMI 310, notamment pour un découpage par leurs interrupteurs. A cet effet, le bloc capacitif 315 est connecté au module de puissance 300 et à la carte SMI par une barre de connexion électrique (non représentée). L'ouverture traversante 115 de la première paroi d'interface 111 est à l'extérieur de la zone 111a de la première paroi d'interface 111 qui est destinée à former le circuit de refroidissement 200. L'ouverture 125 de la deuxième paroi d'interface 121 est à l'extérieur de la zone 121a de la deuxième paroi d'interface 121 qui est destiné à former le circuit de refroidissement 200. Le joint d'étanchéité comprend un trou 138 pour permettre le passage du bloc capacitif 315.

L'invention ne se limite pas au seul exemple décrit ci-dessus. Les figures représentent un exemple particulier de réalisation qui combine plusieurs modes de réalisation. Cependant, les caractéristiques liées aux modes de réalisation peuvent-être indépendantes entre elles d'un mode à l'autre, ou combinées entre elles, comme cela ressort des revendications.

## Revendications

1. Ensemble (100) formant boitier pour un équipement électrique, ledit ensemble (100) comprenant :
- un premier boitier (110) destiné à recevoir au moins un premier composant électronique (300, 310, 370, 315) dudit équipement électrique ;
- un deuxième boitier (120) destiné à recevoir au moins un deuxième composant électronique (320, 330, 340, 350) dudit équipement électrique ;
une première paroi, dite première paroi d'interface (111), du premier boitier (110) et une deuxième paroi, dite première paroi d'interface (121), du deuxième boitier (120) étant configurées pour venir en appui l'une contre l'autre pour former ledit ensemble (100) ; ensemble (100) dans lequel :
- le premier (110) et le deuxième (120) boîtiers comprennent chacun au moins une paroi latérale, dites respectivement première (116c) et deuxième (126c) parois latérales, s'étendant respectivement depuis la première paroi d'interface (111) et la première paroi d'interface (121) dans une direction opposée à l'autre boitier ; et
- la deuxième paroi latérale (126c) comprend une ouverture, dite ouverture de connexion (20), destinée à recevoir un connecteur électrique ;
l'ensemble étant **caractérisé en ce que** la deuxième paroi latérale (126c) comprend une portion autour de la dite ouverture, dite portion de connexion (22), destinée à recevoir une pièce d'étanchéité (381a) dudit connecteur électrique, lesdites première (111) et deuxième (121) parois latérales étant configurées de sorte que ladite portion de connexion (22) s'étend en direction du premier boitier (110) de manière à venir en vis-à-vis d'une face externe (23) de la première paroi latérale (116c).

2. Ensemble (100) selon la revendication 1, dans lequel les dites première (116c) et deuxième (126c) parois latérales forment chacune une paroi extérieure de leur boitier respectif, ladite ouverture de connexion (20) étant configurée pour recevoir un connecteur électrique (381) destiné à connecter électriquement un composant de l'équipement électrique (1) depuis l'extérieur de l'ensemble (100) formant boitier.

3. Ensemble (100) selon la revendication 1 ou 2, dans lequel au moins une partie (22a) de la portion de connexion (22) de la deuxième paroi latérale (126c) vient dans un décrochement (24) correspondant situé dans la face (23) de la première paroi latérale (116c).

4. Ensemble (100) pour un équipement électrique selon la revendication 3, dans lequel ladite partie (22a) de la portion de connexion (22) a une épaisseur configurée pour correspondre avec la profondeur du décrochement (24) et comprend un trou destiné à recevoir un organe de fixation de la pièce d'étanchéité (381a) dudit connecteur électrique (381) sur la dite portion de connexion (22).

5. Ensemble (100) pour un équipement électrique selon l'une des revendications précédentes, dans lequel :
la première paroi d'interface (121) comprend une excroissance (26), ladite excroissance (26) coopérant avec un bord de ladite ouverture de connexion (20) pour permettre un passage d'une connexion électrique entre le connecteur électrique (381) et un composant de l'équipement électrique (1) ;
la première paroi d'interface (111) comprend un décrochement (27) configuré pour recevoir ladite excroissance (26) de la première paroi d'interface (121).

6. Equipement électrique (1) comprenant :
- un ensemble (100) selon l'une des revendications précédentes,
- au moins un premier composant électrique (300, 310, 370, 315) logé dans le premier boitier (110),
- au moins un deuxième composant électrique (320, 330, 340, 350) logé dans le deuxième boitier (120),
- un premier connecteur électrique (381) passant à travers l'ouverture de connexion (20) et connecté électriquement à un composant électrique (320) de l'équipement électrique (1), une pièce d'étanchéité (381a) du premier connecteur électrique (381) étant fixée sur la dite portion de connexion (22).

7. Equipement électrique (1) selon la revendication 6 comprenant :
- des interrupteurs d'un onduleur et/ou des interrupteurs d'un convertisseur de tension DC/DC logés dans le premier boitier (110) ; et
- des composants de filtrage et de redressement logés dans le deuxième boitier (120).

8. Equipement électrique (1) selon la revendication 6 ou 7, dans lequel le premier connecteur électrique (381) est destiné à permettre un échange d'énergie électrique entre les composants de l'équipement électrique (1) et un composant extérieur à l'équipement électrique (1).

9. Equipement électrique (1) selon l'une des revendications 6 à 8, dans lequel la première (111) et la deuxième (121) paroi comprennent respectivement au moins un trou traversant (114, 124) dont les bords viennent en correspondance pour former un passage pour une connexion électrique entre le premier (311) et le deuxième (340) composant électrique.

10. Equipement électrique (1) selon la revendication 9, dans lequel la connexion électrique entre le premier (311) et le deuxième (340) composant est réalisée par un deuxième connecteur électrique (360) comprenant :
- une pièce rigide (361) conductrice électriquement couverte d'un revêtement (362) en matière isolante électriquement,
- une première extrémité (361a) connectée électriquement à une borne électrique du premier composant (311), et
- une deuxième extrémité (361b) connectée électriquement à une borne du deuxième composant (340).

## Patentansprüche

1. Anordnung (100), die ein Gehäuse für eine elektrische Ausrüstung bildet, wobei die Anordnung (100) umfasst:
- ein erstes Gehäuse (110), das zur Aufnahme von mindestens einer ersten elektronischen Komponente (300, 310, 370, 315) der elektrischen Ausrüstung bestimmt ist;
- ein zweites Gehäuse (120), das zur Aufnahme von mindestens einer zweiten elektronischen Komponente (320, 330, 340, 350) der elektrischen Ausrüstung bestimmt ist;
wobei eine erste Wand, bezeichnet als erste Schnittstellenwand (111), des ersten Gehäuses (110) und eine zweite Wand, bezeichnet als erste Schnittstellenwand (121), des zweiten Gehäuses (120) ausgelegt sind, um sich aneinander abzustützen, um die Anordnung (100) zu bilden; wobei bei der Anordnung (100):
- das erste (110) und das zweite (120) Gehäuse jedes mindestens eine Seitenwand, bezeichnet jeweils als erste (116c) und zweite (126c) Seitenwand, umfassen, die sich jeweils ab der ersten Schnittstellenwand (111) und der ersten Schnittstellenwand (121) in einer Richtung entgegengesetzt zum anderen Gehäuse erstrecken; und
- die zweite Seitenwand (126c) eine Öffnung, bezeichnet als Verbindungsöffnung (20), umfasst, die zur Aufnahme eines elektrischen Verbinders bestimmt ist;
wobei die Anordnung **dadurch gekennzeichnet ist, dass** die zweite Seitenwand (126c) einen Abschnitt um die Öffnung, bezeichnet als Verbindungsabschnitt (22), umfasst, der zur Aufnahme eines Dichtungsteils (381a) des elektrischen Verbinders bestimmt ist, wobei die erste (111) und zweite (121) Seitenwand derart ausgelegt sind, dass sich der Verbindungsabschnitt (22) in Richtung des ersten Gehäuses (110) derart erstreckt, dass er gegenüber einer Außenfläche (23) der ersten Seitenwand (116c) gelangt.

2. Anordnung (100) nach Anspruch 1, wobei die erste (116c) und zweite (126c) Seitenwand jede eine Außenwand ihres jeweiligen Gehäuses bilden, wobei die Verbindungsöffnung (20) ausgelegt ist, um einen elektrischen Verbinder (381) aufzunehmen, der zur elektrischen Verbindung einer Komponente der elektrischen Ausrüstung (1) von außerhalb der das Gehäuse bildenden Anordnung (100) bestimmt ist.

3. Anordnung (100) nach Anspruch 1 oder 2, wobei mindestens ein Teil (22a) des Verbindungsabschnitts (22) der zweiten Seitenwand (126c) in eine entsprechende Aussparung (24) eingreift, die sich in der Fläche (23) der ersten Seitenwand (116c) befindet.

4. Anordnung (100) für eine elektrische Ausrüstung nach Anspruch 3, wobei der Teil (22a) des Verbindungsabschnitts (22) eine Dicke hat, die ausgelegt ist, um mit der Tiefe der Aussparung (24) übereinzustimmen und ein Loch umfasst, das zur Aufnahme eines Befestigungsorgans des Dichtungsteils (381a) des elektrischen Verbinders (381) auf dem Verbindungsabschnitt (22) bestimmt ist.

5. Anordnung (100) für eine elektrische Ausrüstung nach einem der vorangehenden Ansprüche, wobei:
die erste Schnittstellenwand (121) einen Vorsprung (26) umfasst, wobei der Vorsprung (26) mit einem Rand der Verbindungsöffnung (20) zusammenwirkt, um einen Durchgang einer elektrischen Verbindung zwischen dem elektrischen Verbinder (381) und einer Komponente der elektrischen Ausrüstung (1) zu gestatten;
die erste Schnittstellenwand (111) eine Aussparung (27) umfasst, die ausgelegt ist, um den Vorsprung (26) der ersten Schnittstellenwand (121) aufzunehmen.

6. Elektrische Ausrüstung (1), umfassend:
- eine Anordnung (100) nach einem der vorangehenden Ansprüche,
- mindestens eine erste elektrische Komponente (300, 310, 370, 315), die im ersten Gehäuse (110) untergebracht ist,
- mindestens eine zweite elektrische Komponente (320, 330, 340, 350), die im zweiten Gehäuse (120) untergebracht ist,
- einen ersten elektrischen Verbinder (381), der durch die Verbindungsöffnung (20) geht und mit einer elektrischen Komponente (320) der elektrischen Ausrüstung (1) elektrisch verbunden ist, wobei ein Dichtungsteil (381a) des ersten elektrischen Verbinders (381) auf dem Verbindungsabschnitt (22) befestigt ist.

7. Elektrische Ausrüstung (1) nach Anspruch 6, umfassend:
- Schalter eines Wechselrichters und/oder Schalter eines Gleichstrom-Gleichstrom-Wandlers, die in dem ersten Gehäuse (110) untergebracht sind; und
- Filter- und Gleichrichterkomponenten, die in dem zweiten Gehäuse (120) untergebracht sind.

8. Elektrische Ausrüstung (1) nach Anspruch 6 oder 7, wobei der erste elektrische Verbinder (381) bestimmt ist, einen Austausch elektrischer Energie zwischen den Komponenten der elektrischen Ausrüstung (1) und einer zu der elektrischen Ausrüstung (1) äußeren Komponente zu gestatten.

9. Elektrische Ausrüstung (1) nach einem der Ansprüche 6 bis 8, wobei die erste (111) und die zweite (121) Wand jeweils mindestens ein Durchgangsloch (114, 124) umfassen, dessen Ränder in Übereinstimmung kommen, um einen Durchgang für eine elektrische Verbindung zwischen der ersten (311) und der zweiten (340) elektrischen Komponente zu bilden.

10. Elektrische Ausrüstung (1) nach Anspruch 9, wobei die elektrische Verbindung zwischen der ersten (311) und der zweiten (340) Komponente durch einen zweiten elektrischen Verbinder (360) durchgeführt wird, umfassend:
- ein elektrisch leitendes starres Teil (361), das von einer Beschichtung (362) aus elektrisch isolierendem Material bedeckt ist,
- ein erstes Ende (361a), das mit einer elektrischen Klemme der ersten Komponente (311) elektrisch verbunden ist, und
- ein zweites Ende (361b), das mit einer Klemme der zweiten Komponente (340) elektrisch verbunden ist.

## Claims

1. Assembly (100) forming a casing for electrical equipment, said assembly (100) comprising:
- a first casing (110) for receiving at least a first electronic component (300, 310, 370, 315) of the electrical equipment;
- a second casing (120) for receiving at least a second electronic component (320, 330, 340, 350) of the electrical equipment;
a first wall known as the first interface wall (111) of the first casing (110) and a second wall known as the first interface wall (121) of the second casing (120), said walls arranged to press against one another to form the assembly (100);
assembly (100) wherein:
- the first (110) and the second (120) casings each comprise at least a side wall respectively known as the first (116c) and second (126c) side walls, which extend respectively from the first interface wall (111) and the second interface wall (121) in an opposite direction relative to the other casing; and
- the second side wall (126c) has an opening, known as the connection opening (20), for receiving an electrical connector;
the assembly being **characterised in that** the second side wall (126c) comprises a portion surrounding the opening, known as the connection portion (22), for receiving a sealing part (381a) of the electrical connector, with said first (111) and second (121) side walls being arranged such that the connection portion (22) extends towards the first casing (110) so as to face one external surface (23) of the first side wall (116c).

2. Assembly (100) according to Claim 1 whereby the first (116c) and second (126c) side walls each form an outer wall of their respective casings, with the connection opening (20) arranged for receiving an electrical connector (381) to connect a component of the electrical equipment (1) from outside the assembly (100) forming the casing.

3. Assembly (100) according to Claim 1 or 2 whereby at least a part (22a) of the connection portion (22) of the second side wall (126c) fits into a corresponding projection (24) located on the surface (23) of the first side wall (116c).

4. Assembly (100) for electrical equipment according to Claim 3 whereby said part (22a) of the connection portion (22) has a thickness designed to match with the depth of the projection (24) and has a hole to receive the device to fasten the sealing part (381a) of the electrical connection (381) to the connection portion (22).

5. Assembly (100) for electrical equipment according to any of the preceding Claims whereby:
- the first interface wall (121) comprises a protrusion (26), said protrusion (26) engaging with the edge of the connection opening (20) to create a passage for an electrical connection between the electrical connector (381) and a component of the electrical equipment (1);
- the first interface wall (111) comprises a projection (27) arranged for receiving the protrusion (26) from the first interface wall (121).

6. Electrical equipment (1) comprising:
- an assembly (100) according to any of the preceding Claims;
- at least a first electrical component (300, 310, 370, 315) housed in the first casing (110);
- at least a second electrical component (320, 330, 340, 350) housed in the second casing (120);
- a first electrical connector (381) passing through the connection opening (20) and connected electrically to an electrical component (320) of the electrical equipment (1), a sealing part (381a) of the first electrical connector (381) fitted on the connection portion (22).

7. Electrical equipment (1) according to Claim 6, comprising:
- switches of an inverter and/or switches of a DC/DC voltage converter housed in the first casing (110); and
- filtering and rectification components housed in the second casing (120).

8. Electrical equipment (1) according to Claim 6 or 7 whereby the first electrical connector (381) is designed to exchange power between the components of the electrical equipment (1) and a component outside the electrical equipment (1).

9. Electrical equipment (1) according to one of Claims 6 to 8 whereby the first (111) and second (121) walls respectively have at least a through-hole (114, 124) with edges that fit into each other to create a passage for an electrical connection between the first (311) and the second (340) electrical components.

10. Electrical equipment (1) according to Claim 9 whereby the electrical connection between the first (311) and the second (340) components is provided by a second electrical connector (360) comprising:
- an electrically-conductive rigid part (361) covered with an electrically-insulated material coating (362);
- a first end (361a) electrically connected to an electric terminal of the first component (311); and
- a second end (361b) electrically connected to an electric terminal of the second component (340).
